# FASCICULE DE BREVET EUROPEEN

(11) **EP 0 470 897 B1**
(45) Date de publication et mention de la délivrance du brevet: **15.12.1993**
(21) Numéro de dépôt: 91402169.6
(22) Date de dépôt: 02.08.1991
(51) Int. Cl.: G11C 29/00, G06F 11/20

(54) **Circuit intégré de mémoire avec redondance et adressage amélioré en mode de test**
Integrierte Speicherschaltung mit Redundanz und verbesserter Adressierung in Testbetriebsart
Integrated memory circuit with redundancy and improved addressing in test mode

(30) Priorité: 10.08.1990 FR 9010247
(43) Date de publication de la demande: 12.02.1992
(73) Titulaire: SGS-THOMSON MICROELECTRONICS S.A., 94250 Gentilly (FR)
(72) Inventeur: Conan, Bertrand, Cabinet Ballot-Schmit, F-75116 Paris (FR)
(74) Mandataire: Schmit, Christian Norbert Marie

(56) Documents cités:
- EP-A- 0 050 005
- EP-A- 0 264 893
- RESEARCH DISCLOSURE, no. 299, Mars 1989, HAVANT GB DISCLOSURE NO. 29929: 'Fast Write Scheme for Memory Test Patterns'
- IEEE ELECTRO, vol. 7, mai 1982, pages 26/3(1-6), New York, US; J.P.ALTNETHER et al.: "Testing Redundant Memories"

## Description

L'invention concerne les mémoires réalisées en circuit intégré, tout particulièrement mais non exclusivement les mémoires non volatiles programmables électriquement.

Dans les mémoires de grande capacité (plusieurs dizaines de milliers de cellules de mémoire), on a l'habitude, pour améliorer les rendements de fabrication, d'associer au plan mémoire plusieurs colonnes (ou lignes) de redondance destinées à se substituer à des colonnes (ou lignes) défectueuses du plan mémoire (voir EP-A- 0 264 893). Dans la suite, pour simplifier, on ne parlera plus que de colonnes mais il pourrait s'agir aussi de lignes.

Pour l'utilisateur, la substitution doit être transparente, c'est-à-dire qu'il est autorisé à envoyer à l'entrée d'adressage de la mémoire une adresse correspondant à une colonne défectueuse; la circuiterie interne de redondance se charge alors de neutraliser la colonne défectueuse et de lire ou écrire une information dans une cellule d'une colonne de remplacement au lieu de tenter de la lire ou de l'écrire dans une cellule de la colonne défectueuse.

Cette transparence impose de placer à l'entrée de la mémoire des circuits de reconnaissance des adresses défectueuses, des circuits de désélection pour neutraliser les colonnes défectueuses, et des circuits de routage vers les colonnes de remplacement.

Tous ces circuits modifient donc de manière importante le décodage initial des adresses de la mémoire, décodage qui consistait à associer une colonne déterminée à une adresse d'entrée déterminée.

Or il se trouve qu'en dehors du mode d'utilisation normale des mémoires (lecture et écriture par un utilisateur avec transparence complète dans le cas où des colonnes redondantes ont été mises en service), il existe un deuxième mode qui est le mode de test.

En effet, il est nécessaire que toutes les cellules des mémoires soient testées avant que le circuit soit déclaré apte à être vendu. Le test consiste notamment à programmer toutes les cellules de leur état initial (état vierge) vers un état "programmé" et à vérifier qu'elles sont correctement programmées. C'est d'ailleurs en général au cours de ce test qu'on détecte des colonnes défectueuses et qu'on met en service des colonnes de remplacement.

Le test d'une cellule de mémoire peut prendre quelques millisecondes. Mais les circuits intégrés sont fabriqués par lots, et chaque lot comporte des dizaines de tranches de silicium portant chacune plusieurs dizaines de puces qui portent elles mêmes chacune plusieurs dizaines ou centaines de milliers de cellules de mémoire; les opérations de test peuvent alors prendre un temps considérable puisqu'il faut tester systématiquement toutes les cellules.

Pour réduire ce temps de test, on a proposé que les cellules soient programmées selon un motif (par exemple un motif en damier) qui permette la programmation simultanée de plusieurs colonnes de points mémoire. Autrement dit, en mode de test, au lieu d'écrire individuellement dans une colonne puis dans une autre, etc, on écrit simultanément une même information en parallèle dans plusieurs colonnes à la fois, par exemple 2 ou 4 ou 8 colonnes à la fois. Le temps de test est divisé d'autant (voir EP-A-0 050 005).

On peut appeler dans la suite "test groupé" ce mode de test dans lequel on programme plusieurs colonnes à la fois.

On a remarqué selon l'invention que dans les mémoires existantes on ne pouvait pas faire deux fois de suite un test groupé alors qu'on peut très bien avoir besoin de le faire dans certaines circonstances.

Par exemple, on a besoin de recommencer un test pour tout un lot dans le cas où une fausse manoeuvre a été effectuée au cours du test du lot; ou encore si le testeur est tombé en panne et que la panne n'a pas été détectée assez vite, etc.

Et on ne peut pas refaire le test en mode "groupé" pour les lots déjà testés : en effet, des colonnes de redondance ont été mises en service (de manière irréversible) dans certaines puces, et cette mise en service s'accompagne de modifications importantes de l'adressage interne de la mémoire. Or le mode de test "groupé" nécessite lui aussi une modification de l'adressage interne de la mémoire puisqu'il exige d'adresser simultanément plusieurs colonnes.

On s'est aperçu que les modifications d'adressage dues à la mise en service de colonnes de redondance étaient en pratique incompatibles avec les modifications d'adressage requises pour effectuer un mode de test groupé. Il n'est donc pas possible de refaire un test groupé si le premier test effectué a abouti à la mise en service de colonnes de remplacement.

Dans une réalisation particulière de la mémoire, il y a un décodeur (DEC) d'adresses de colonne recevant sur des entrées d'adresse (A1 ...) les bits d'une adresse de colonne et sur des entrées complémentaires (NA1 ..) les compléments de ces bits, une mémoire de redondance (MR, MR') pour stocker des adresses de colonnes défectueuses, un circuit (SW, CMP) de comparaison des adresses reçues et des adresses de colonnes défectueuses; le circuit de comparaison comportant une porte NOR (CMP) à plusieurs entrées, chaque entrée recevant un bit dont le niveau logique dépend de l'identité entre un bit reçu sur une entrée du décodeur et un bit correspondant de la mémoire de redondance; un moyen de sélection/désélection (DSL) étant prévu pour sélectionner une colonne de remplacement et simultanément inhiber la sélection de toutes les autres colonnes lorsque la sortie de la porte NOR indique qu'une adresse reçue est identique à une adresse défectueuse; le test groupé étant commandé par un circuit logique qui, en réponse à un signal (G) de commande de test groupé, place un niveau logique identique sur au moins une entrée et une entrée complémentaire correspondante du décodeur pour sélectionner simultanément un groupe de colonnes, le signal de commande de test groupé étant appliqué au circuit de comparaison pour sélectionner simultanément toute colonne de remplacement d'une colonne défectueuse de ce groupe et le signal de commande de test groupé étant appliqué au moyen de sélection/désélection (DSL) pour annuler l'inhibition de la sélection desdites toutes les autres colonnes.

Les caractéristiques et avantages de l'invention apparaîtront à la lecture de la description détaillée qui suit et qui est faite en référence aux dessins annexés dans lesquels :
- la figure 1 représente un circuit de mémoire avec redondance, ne permettant pas un test groupé après que la redondance ait été mise en service;
- la figure 2 représente un circuit de mémoire selon l'invention permettant un test groupé même après mise en service de la redondance.

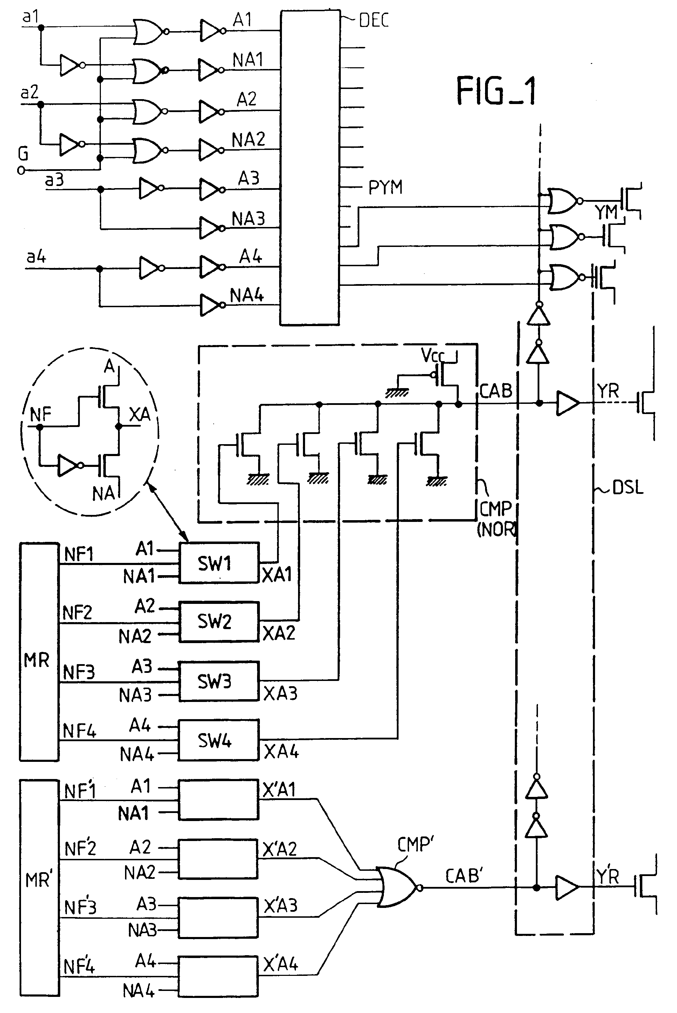

A la figure 1, on a représenté l'architecture globale de la mémoire en circuit intégré ne permettant pas un test groupé après que la redondance ait été mise en service. L'exemple représenté est celui d'une mémoire avec adressage des colonnes par quatre bits d'adresse, avec deux colonnes de redondance susceptibles de remplacer deux colonnes défectueuses, et avec un mode de test groupé permettant de programmer quatre colonnes à la fois. Bien entendu, cette réalisation n'est donnée qu'à titre d'exemple simplifié, les nombres de bits d'adresse et de colonnes étant bien supérieurs dans la pratique.

Le plan mémoire lui-même avec ses lignes et colonnes de cellules n'est pas représenté; l'accès aux colonnes de cellules de mémoire du plan mémoire est établi par un décodeur d'adresses de colonne (DEC) dont les sorties PYM sont en nombre égal au nombre de colonnes de la mémoire : chaque ligne de sortie permet de sélectionner, lorsqu'elle est au niveau logique approprié, une colonne particulière de la mémoire.

Le décodeur reçoit sur des entrées de bit d'adresse et sur des entrées complémentaires respectivement les bits d'adresse A1, A2, A3, A4 et les compléments NA1, NA2, NA3, NA4 de ces bits.

Pour une adresse donnée, une colonne donnée est sélectionnée par le décodeur. Mais si on force au même niveau logique 1 (au lieu de niveaux complémentaires 1 et 0) une entrée et l'entrée complémentaire correspondante (par exemple A1 et NA1) du décodeur, deux colonnes sont sélectionnées. Et si on force deux entrées et les deux entrées complémentaires correspondantes (par exemple A1 et A2 et NA1 et NA2) toutes au même niveau logique 1, alors quatre colonnes sont sélectionnées simultanément. Les quatre colonnes qui sont ainsi sélectionnées simultanément sont définies par les autres bits d'adresse (A3 et A4 ici).

C'est ce qui est mis à profit pour effectuer, en mode de test, un test "groupé" avec programmation simultanée de plusieurs colonnes.

Pour cela, un signal de commande de test groupé G est appliqué à un ensemble de portes logiques (portes NOR) interposées entre les entrées d'adresse de la mémoire et les entrées du décodeur. Lorsque G est au niveau logique 1, un niveau 1 est appliqué à la fois sur les entrées A1, A2 et les entrées complémentaires NA1, NA2 du décodeur. Lorsque G=0, les entrées NA1 et NA2 sont les compléments des entrées A1 et A2. Le signal G n'agit pas sur les autres bits d'adresse dans cette réalisation où le test groupé consiste à programmer quatre colonnes à la fois.

Pour la réparation de colonnes défectueuses, la mémoire est organisée de la manière suivante : un circuit de désélection DSL permet de désélectionner la colonne désignée par le décodeur et de sélectionner à la place une colonne de remplacement. Ce circuit DSL reçoit les sorties PYM du décodeur et un signal de commande de désélection CAB. Si CAB est au niveau logique 1, la sortie PYM est inhibée et ne permet plus de sélectionner la colonne désignée par le décodeur. Le signal CAB est fourni par un circuit de comparaison CMP; il est à 1 quand l'adresse présentée à l'entrée du décodeur est une adresse de colonne défectueuse.

Plus précisément, le circuit DSL reçoit les sorties PYM de désignation de colonne à sélectionner et il fournit, sous le contrôle du signal de désélection CAB, autant de sorties YM qui sont des lignes de commande de sélection des colonnes de la mémoire et une sortie additionnelle YR qui est une ligne de commande de sélection d'une première colonne redondante.

Dans l'exemple représenté on a prévu en fait deux colonnes de redondance, par exemple une associée à une moitié des colonnes et l'autre à l'autre moitié, ou toutes les deux associées à l'ensemble des colonnes; le signal CAB permet de désélectionner une colonne défectueuse pour sélectionner à la place la première colonne de remplacement; cette sélection se fait par la ligne de commande YR; un signal CAB' permet de désélectionner une colonne défectueuse pour sélectionner une autre colonne de remplacement en activant une autre ligne de commande YR'.

Les adresses de colonnes défectueuses, repérées lors du test de la mémoire, sont stockées dans des mémoires de redondance, réalisées sous forme de batteries de fusibles ou de mémoires électriquement programmables et non effaçables (UPROM). Une première adresse à quatre bits est stockée dans une zone de mémoire MR associée à la première colonne de remplacement; une autre adresse peut être stockée dans une deuxième zone de mémoire de redondance MR' associée à la deuxième colonne de remplacement. Ces deux adresses représentent les adresses de deux colonnes défectueuses de la mémoire.

Par comparaison entre l'adresse reçue et l'adresse stockée en mémoire MR on élabore le signal de désélection CAB. Par comparaison entre l'adresse reçue et l'adresse stockée en MR', on élabore le signal CAB'.

La comparaison est effectuée à partir de circuits organisés de la manière suivante : les bits d'adresse de colonne défectueuse, représentés par les sorties NF1, NF2, NF3, NF4, de la mémoire MR, servent à commander chacun un aiguillage respectif SW1, SW2, SW3, SW4. Chaque aiguillage reçoit par ailleurs les signaux présents sur une entrée et une entrée complémentaire respective du décodeur. Ainsi, l'aiguillage SW1 reçoit comme signal de commande NF1 (premier bit d'adresse de colonne défectueuse) et comme signaux à aiguiller A1 (première entrée du décodeur DEC) et NA1 (première entrée complémentaire du décodeur). Selon l'état de NF1, c'est A1 ou NA1 qui est aiguillé à la sortie de SW1. Le signal de sortie XA1 de l'aiguillage SW1 est alors égal à 0 si le bit d'adresse stocké correspond au bit d'adresse reçue à l'entrée de la mémoire. Quand tous les bits d'adresse stockés dans la mémoire MR correspondent justement aux bits d'adresse reçus par la mémoire, tous les signaux de sortie XA1 à XA4 des aiguillages connectés en sortie de la mémoire de redondance passent tous à 0. Le signal de désélection CAB est alors activé. Une simple porte NOR (désignée par CMP sur la figure) recevant tous les signaux XA1 à XA4 fournit à sa sortie le signal CAB. Cette porte NOR est ici réalisée par des transistors en parallèle dont les grilles reçoivent les signaux XA1 à XA4.

L'élaboration du signal CAB' est identique, à partir du contenu de la mémoire MR'.

En pratique, pour élaborer XA1 à partir de NF1, de A1, et de NA1, on utilise un petit circuit d'aiguillage SW1 à deux transistors à canal N en série entre A1 et NA1, leurs grilles étant commandées par NF1 et l'inverse de NF1 respectivement. Les autres circuits d'aiguillage sont identiques.

Or ce circuit fournit XA1 comme désiré (XA1 = 0 si le bit d'adresse reçu correspond au bit stocké) seulement si A1 et NA1 sont bien des signaux complémentaires. Si A1 et NA1 sont tous deux égaux à 1, XA1 ne peut pas être autre chose que 1. Et si XA1 (ou XA2) est égal à 1, le signal CAB ne peut plus passer à 1.

Il résulte de cela que la colonne de redondance ne peut pas être sélectionnée dès lors que A1 et NA1 sont tous deux égaux à 1; or c'est ce qui se passe en mode de test groupé : A1 et NA1 sont tous deux égaux à 1, de même que A2 et NA2 d'ailleurs.

Lors du premier test de la mémoire, cela n'a pas d'importance, aucune colonne de redondance n'a été mise en service. Mais si on veut faire un deuxième test groupé après avoir mis en service des colonnes de redondance parce qu'il y a des colonnes défectueuses, les colonnes défectueuses seront à nouveau testées, mais il n'y aura évidemment plus de possibilité de les réparer puisqu'elles l'ont en fait déjà été; et même si elles étaient remplacées à nouveau, on ne pourrait de toutes façons pas vérifier (en mode de test groupé) que la réparation est correcte.

On comprendra donc qu'il n'est pas possible de refaire un test groupé.

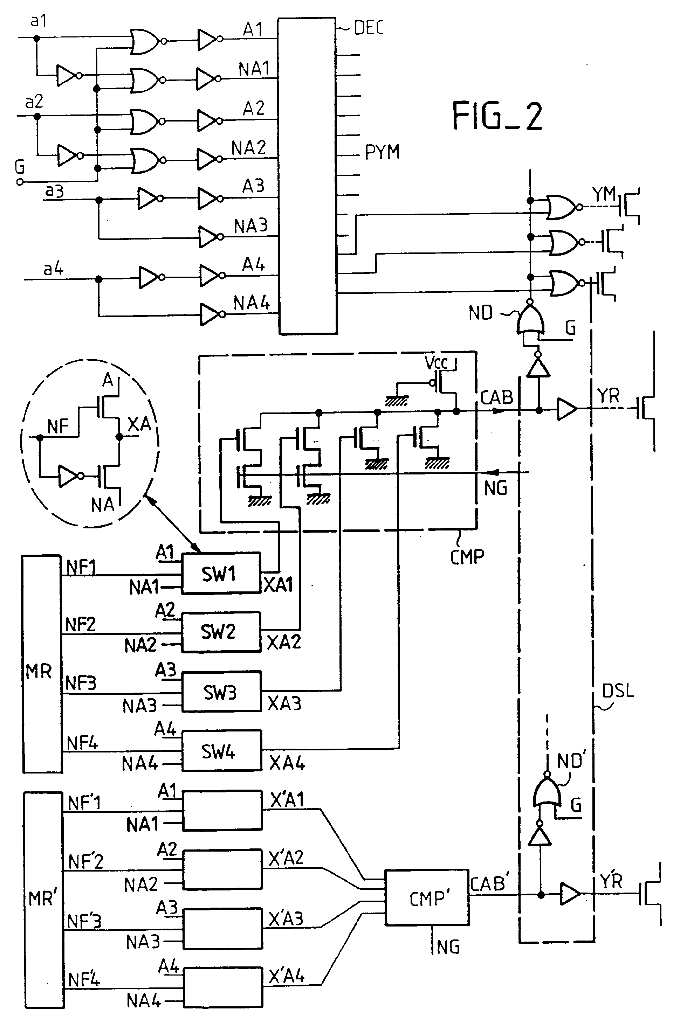

Avec le circuit de la figure 2, le test groupé redevient possible.

Pour cela on prévoit que les circuits de comparaison (porte NOR CMP et aiguillages SW1 à SW4) sont modifiés pour empêcher la désélection systématique de la colonne de redondance en mode de test groupé.

Dans l'exemple décrit la porte NOR CMP est modifiée de la manière suivante : elle reçoit le complément NG du signal G de commande de test groupé. Ce signal NG interdit la mise à zéro du signal CAB sous l'effet des signaux XA1 et XA2, c'est-à-dire des signaux de sortie des aiguillages SW1 et SW2 qui correspondent aux bits d'adresse groupés lors du test groupé.

Ainsi, lorsque les bits A3 et A4 correspondront à une adresse de colonne défectueuse, le signal CAB passera à 1 et permettra la sélection de la colonne redondante; en effet, la colonne défectueuse est alors une des quatre colonnes sélectionnées par le test groupé et elle doit être remplacée par la colonne redondante.

Toutefois, il ne faudrait pas désélectionner les quatre colonnes groupées puisqu'elles doivent être testées (alors que le passage à 1 du signal CAB les désélectionne toutes); c'est pourquoi on interpose dans le circuit de désélection DSL une porte logique ND recevant le signal CAB ou son complément et le signal G de test groupé ou son complément; cette porte neutralise la désélection lorsque le signal G indique qu'on est en mode de test groupé. La porte ND empêche que le signal CAB vienne affecter la transmission des signaux de sortie PYM du décodeur vers les colonnes du plan mémoire.

Bien entendu, les mêmes dispositions sont prises pour l'élaboration et la transmission du signal CAB' : modification d'une porte NOR CMP' par le signal NG et interposition d'une porte logique ND' commandée par G.

## Revendications

1. Mémoire en circuit intégré avec circuits de redondance (MR, MR', SW, CMP) pour remplacer des colonnes de cellules mémoires défectueuses par des colonnes de redondance, cette mémoire comportant des moyens d'adressage (DEC, G) permettant en mode normal d'adresser individuellement chaque colonne et permettant en mode de test groupé d'adresser simultanément un groupe de plusieurs colonnes en vue de les programmer simultanément, caractérisée en ce qu'elle comporte :
- un décodeur (DEC) d'adresses de colonne recevant sur des entrées d'adresse (A1 ...) les bits d'une adresse de colonne et sur des entrées complémentaires (NA1 ..) les compléments de ces bits, une mémoire de redondance (MR, MR') pour stocker des adresses de colonnes défectueuses, un circuit (SW, CMP) de comparaison des adresses reçues et des adresses de colonnes défectueuses; le circuit de comparaison comportant une porte NOR (CMP) à plusieurs entrées, chaque entrée recevant un bit dont le niveau logique dépend de l'identité entre un bit reçu sur une entrée du décodeur et un bit correspondant de la mémoire de redondance; un moyen de sélection/désélection (DSL) étant prévu pour sélectionner une colonne de remplacement et simultanément inhiber la sélection de toutes les autres colonnes lorsque la sortie de la porte NOR indique qu'une adresse reçue est identique à une adresse défectueuse; le test groupé étant commandé par un circuit logique qui, en réponse à un signal (G) de commande de test groupé, place un niveau logique identique sur au moins une entrée et une entrée complémentaire correspondante du décodeur pour sélectionner simultanément un groupe de colonnes, le signal de commande de test groupé étant appliqué au circuit de comparaison pour sélectionner simultanément toute colonne de remplacement d'une colonne défectueuse de ce groupe et le signal de commande de test groupé étant appliqué au moyen de sélection/désélection (DSL) pour annuler l'inhibition de la sélection desdites toutes les autres colonnes.

## Patentansprüche

1. Integrierte Speicherschaltung mit Redundanzschaltungen (MR, MR', SW, CMP) zum Ersatz von fehlerhaften Speicherzellenspalten durch Redundanzspalten, wobei der Speicher Adressierungsmittel (DEC, G) enthält, die es in der normalen Betriebsart ermöglichen, jede Spalte individuell zu adressieren, und es in einer Gruppentestbetriebsart ermöglichen, gleichzeitig eine Gruppe von mehreren Spalten zu adressieren, um sie gleichzeitig zu programmieren, dadurch gekennzeichnet, daß sie enthält:
- einen Spaltenadressendecodierer (DEC), der an Adresseneingängen (A1 ...) die Bits einer Spaltenadresse und an komplementären Eingängen (NA1 ..) die Komplemente dieser Bits empfängt, einen Redundanzspeicher (MR, MR') zur Speicherung der Adressen fehlerhafter Speicher, eine Vergleichsschaltung (SW, CMP) zum Vergleich der empfangenen Adressen und der Adressen fehlerhafter Spalten; wobei die Vergleichsschaltung ein NOR-Gatter (CMP) mit mehreren Eingängen enthält, wovon jeder Eingang ein Bit empfängt, dessen Logikpegel von der Identität zwischen einem an einem Eingang des Decodierers empfangenen Bit und einem entsprechenden Bit des Redundanzspeichers abhängt; wobei ein Auswahl-/Abwahlmittel (DSL) vorgesehen ist, um eine Ersatzspalte auszuwählen und gleichzeitig die Auswahl aller anderen Spalten zu sperren, wenn der Ausgang des NOR-Gatters anzeigt, daß eine empfangene Adresse mit einer fehlerhaften Adresse identisch ist; wobei der Gruppentest von einer Logikschaltung gesteuert wird, die als Reaktion auf ein Gruppentest-Steuersignal (R) einen identischen Logikpegel an wenigstens einen Eingang und einen entspechenden komplementären Eingang des Decodierers anlegt, um gleichzeitig eine Spaltengruppe auszuwählen, wobei das Gruppentest-Steuersignal an die Vergleichsschaltung angelegt wird, um gleichzeitig jede Ersatzspalte einer fehlerhaften Spalte dieser Gruppe auszuwählen, und wobei das Gruppentest-Steuersignal an die Auswahl-/Abwahlmittel (DSL) angelegt wird, um die Sperrung der Auswahl aller anderen Spalten aufzuheben.

## Claims

1. Integrated-circuit memory with redundancy circuits (MR, MR', SW, CMP) for replacing defective memory cell columns with redundancy columns, this memory having addressing means (DEC, G) enabling each column to be addressed individually in normal mode and enabling a group of several columns to be addressed simultaneously in grouped test mode with a view to programming them simultaneously, characterised in that it includes:
- a column address decoder (DEC) receiving the bits of a column address at address inputs (A1 ...) and the complements of these bits at complementary inputs (NA1 ...), a redundancy memory (MR, MR') for storing defective column addresses, a circuit (SW, CMP) for comparing received addresses and defective column addresses; the comparator circuit having a NOR gate (CMP) with several inputs, each input receiving a bit, the logic level of which depends on whether a bit received at an input of the decoder and a corresponding bit of the redundancy memory are identical; a selection/deselection means (DSL) being provided for selecting a replacement column and simultaneously inhibiting the selection of all the other columns when the NOR gate output indicates that a received address is identical to a defective address; the grouped test being controlled by a logic circuit which, in response to a grouped test control signal (G), places an identical logic level on at least one input and one corresponding complementary input of the decoder so as to select simultaneously a group of columns, the grouped test control signal being applied to the comparator circuit so as to select simultaneously any column replacing a defective column in this group and the grouped test control signal being applied to the selection/deselection means (DSL) in order to cancel the inhibition of the selection of all the other columns.
